# EUROPEAN PATENT SPECIFICATION

(11) **EP 3 916 056 B1**
(45) Date of publication and mention of the grant of the patent: **13.12.2023**
(21) Application number: 20744719.4
(22) Date of filing: 16.01.2020
(51) Int. Cl.: C08L 83/05, C08L 83/07, C08K 3/013, C08K 3/22, C08K 3/28, C08K 3/38, C08L 83/06, H01L 23/36

(54) **HIGHLY THERMALLY CONDUCTIVE SILICONE COMPOSITION AND METHOD FOR PRODUCING SAME**
HOCH WÄRMELEITFÄHIGE SILIKONZUSAMMENSETZUNG UND VERFAHREN ZU IHRER HERSTELLUNG
COMPOSITION DE SILICONE HAUTEMENT THERMOCONDUCTRICE ET SON PROCÉDÉ DE PRODUCTION

(30) Priority: 24.01.2019 JP 2019010407
(43) Date of publication of application: 01.12.2021
(73) Proprietor: SHIN-ETSU CHEMICAL CO., LTD., Tokyo 100-0004 (JP)
(72) Inventor: MARUYAMA Narimi, Annaka-shi, Gunma 379-0224 (JP)
(74) Representative: Mewburn Ellis LLP
(86) International application number: PCT/JP2020/001236
(87) International publication number: WO 2020/153217

(56) References cited:
- WO-A1-2013/168291
- WO-A1-2019/235293
- JP-A- 2006 169 343
- JP-A- 2012 102 283
- JP-A- 2012 107 152
- JP-A- 2014 080 546
- US-B2- 9 394 470

## Description

### TECHNICAL FIELD

The present invention relates to a silicone composition having a high thermal conductivity, and more particularly to a highly thermally conductive silicone composition that has an excellent coating performance and creep resistance. The invention further relates to a method for producing such a composition.

### BACKGROUND ART

Electrical and electronic components generate heat during use, and so heat removal is generally necessary in order to have these components operate properly. Various types of thermally conductive materials used for such heat removal have hitherto been described. Thermally conductive materials for this purpose exist in two forms: (1) sheet-like materials that are easy to handle, and (2) paste-like materials called thermal greases.

Sheet-like materials (1) have the advantage of being easy to handle as well as highly stable. On the other hand, because the thermal contact resistance inevitably rises, the thermal interface performance is inferior to that of thermal greases. Moreover, such materials are required to have a certain degree of strength and rigidity in order to maintain the form of a sheet and so are unable to absorb the tolerances that arise between a component and its housing; as a result, the component is sometimes destroyed by stress from these materials.

By contrast, in the case of thermal greases (2), not only can these be adapted to the mass production of electrical and electronic components through the use of applicators and the like, with their low thermal contact resistance, they also provide the advantage of having an excellent thermal interface performance. However, when the viscosity of a thermal grease is lowered in order to achieve a good coating performance, "creeping" of the grease (the pump-out phenomenon) occurs due to, for example, thermal impacts on the components. Hence, heat removal becomes inadequate, as a result of which component malfunction sometimes arises.

This situation has led to the disclosure of thermally conductive silicone compositions of even higher performance, such as a grease-type silicone composition that combines a specific organopolysiloxane, a thickener such as zinc oxide, alumina, aluminum nitride, boron nitride or silicon carbide, an organopolysiloxane having at least one silicon-bonded hydroxyl group per molecule and an alkoxysilane, and suppresses bleeding of the base oil (Patent Document 1:JP-A H11-49958); a thermally conductive silicone composition of excellent thermal conductivity and dispensability which is obtained by combining a liquid silicone with a thermally conductive inorganic filler having a given thermal conductivity and a Mohs hardness of 6 or more and a thermally conductive inorganic filler having a given thermal conductivity and a Mohs hardness of 5 or less (Patent Document 2: JP-A H11-246884); a thermally conductive grease composition obtained by combining a specific base oil with a metallic aluminum powder having an average particle size of from 0.5 to 50 µm (Patent Document 3: JP-A 2000-63873); a silicone composition wherein the loading of aluminum nitride in the silicone grease has been increased by using in admixture two types of aluminum nitride powders of differing average particle sizes (Patent Document 4: JP-A 2000-169873); and a silicone composition that suppresses bleedout by increasing the oil viscosity (Patent Document 5: JP-A 2003-301184). Also a heat conductive compositions comprising vinyl polyorganosiloxane, organohydrogenpolysiloxane, inorganic filler metal oxide or nitride of average particle size of 1 µm (zinc oxide powder) and heat conductive filler (aluminum powder) of average particle size of 20 µm is known (Patent Document 6: US 9394470 B).

### PRIOR ART DOCUMENTS

### PATENT DOCUMENTS

Patent Document 1: JP-A H11-49958
Patent Document 2: JP-A H11-246884
Patent Document 3: JP-A 2000-63873
Patent Document 4: JP-A 2000-169873
Patent Document 5: JP-A 2003-301184
Patent Document 6: US 9394470 B

### SUMMARY OF INVENTION

### TECHNICAL PROBLEM

The present invention was arrived at in light of the above circumstances. An object of the invention is to provide a highly thermally conductive silicone composition that has excellent creep resistance and coatability. Another object is to provide a method for producing such a composition.

### SOLUTION TO PROBLEM

The inventor, as a result of conducting extensive investigations in order to achieve the above objects, has found that a high thermal conductivity, good creep resistance and good coatability can be obtained by combining in specific amounts: the product of (A) a silicon-bonded alkenyl group-containing organopolysiloxane reacted with (B) an organohydrogenpolysiloxane reacted at a specific molar ratio (Si-H/Si-Vi) therebetween, (C) an inorganic filler having a specific average particle size, and (D) a thermally conductive inorganic filler having a specific average particle size. This discovery ultimately led to the present invention.

Accordingly, the invention provides the following highly thermally conductive silicone composition and method for producing the same.
1. A highly thermally conductive silicone composition that includes:
an organopolysiloxane which is the product of (A) an organopolysiloxane having on average at least 0.1 silicon-bonded alkenyl group per molecule reacted with (B) an organohydrogenpolysiloxane having on average at least 1 silicon-bonded hydrogen atom per molecule at a molar ratio (Si-H/Si-Vi) therebetween of silicon-bonded hydrogen atoms (Si-H groups) in component (B) to silicon-bonded alkenyl groups in component (A) of more than 8.0 and up to 20.0,
(C) an inorganic filler which has an average particle size of not more than 3 µm and is selected from the group consisting of metal oxides and metal nitrides, and
(D) a thermally conductive inorganic filler having an average particle size of at least 5 µm, wherein the silicone composition has a combined amount of components (C) and (D) that is from 3,500 to 12,000 parts by weight per 100 parts by weight of components (A) and (B) combined, a thermal conductivity at 25°C as measured by the hot disk method in accordance with ISO 22007-2 of at least 4 W/m. K and an absolute viscosity at 25°C of from 100 to 1,000 Pa. s.

2. The highly thermally conductive silicone composition of 1 above, wherein the storage moduli measured with a rheometer under the following conditions:

| | |
|---|---|
| Measuring geometry: | parallel plate P20 Ti |
| Measuring gap: | 1.00 mm (liquid volume: 0.4 mL) |
| Testing mode: | Frequency sweep in controlled deformation mode |
| Deformation conditions: | CD-Auto Strain 1.00±0.05% |
| Measuring frequency: | 0.1 to 10 Hz |
| Measuring temperatures: | 25°C±1°C, 150°C±1°C after raising temperature to 150°C at 15°C/min |

are such that the ratio G'(150°C)/G'(25°C) therebetween is from 2 to 20.
3. The highly thermally conductive silicone composition of 1 or 2 above, wherein component (C) has a point of zero charge (PZC) of at least pH 6 and is one or more selected from the group consisting of aluminum oxide powder, zinc oxide powder, magnesium oxide, aluminum nitride and boron nitride powder.
4. The highly thermally conductive silicone composition of any of 1 to 3 above, further including (E) a hydrolyzable organopolysiloxane.
5. The highly thermally conductive silicone composition of 4 above, wherein component (E) is an organopolysiloxane of general formula (1) below

-SiR¹ₐ(OR²)₃₋ₐ (1)

(where R¹ is an unsubstituted or substituted monovalent hydrocarbon group; R² is an alkyl group, alkoxyalkyl group or acyl group; and `a' is 0, 1 or 2) having at least one silyl group per molecule and a viscosity at 25°C of from 0.1 to 30,000 mPa·s and is included in an amount of from 50 to 600 parts by weight per 100 parts by weight of components (A) and (B) combined.
6. A method for producing the highly thermally conductive silicone composition of any of 1 to 3 above, which method includes the steps of:
mixing components (A), (B), (C) and (D) together with a platinum metal-based curing catalyst in such a way that the molar ratio (Si-H/Si-Vi) of Si-H groups in component (B) to silicon-bonded alkenyl groups in component (A) is more than 8.0 and up to 20.0; and
reacting components (A) and (B) by heating the resulting mixture at between 100°C and 180°C for a period of from 30 minutes to 4 hours.

### ADVANTAGEOUS EFFECTS OF INVENTION

The present invention makes it possible to provide a highly thermally conductive silicone composition of excellent creep resistance and coatability, as well as a method for producing such a composition. This highly thermally conductive silicone composition is well-suited for removing heat from electrical and electronic components that generate heat during use. In the description that follows, "highly thermally conductive silicone composition" is sometimes shortened to "silicone composition."

### DESCRIPTION OF EMBODIMENTS

The invention is described in detail below.

### [Organopolysiloxane]

The organopolysiloxane of the invention is the reaction product (cured product) obtained by reacting (A) an organopolysiloxane having on average at least 0.1 silicon-bonded alkenyl group per molecule with (B) an organohydrogenpolysiloxane having on average at least 1 silicon-bonded hydrogen atom per molecule, at a molar ratio (Si-H/Si-Vi) therebetween of silicon-bonded hydrogen atoms (Si-H) groups in component (B) to silicon-bonded alkenyl groups in component (A) of more than 8.0 and up to 20.0. This is sometimes referred to below as simply "the reaction product of components (A) and (B)."

### [Component (A)]

The alkenyl group-containing organopolysiloxane has on average at least 0.1 silicon-bonded alkenyl group per molecule. Each molecule preferably has at least 1 (generally from 1 to 20), and more preferably from 2 to 10, silicon-bonded alkenyl groups thereon. The organopolysiloxane may be of a single type used alone or two or more may be used in suitable combination.

The molecular structure of component (A) is not particularly limited. Exemplary molecular structures include linear structures, linear structures with some branches, branched chain structures, cyclic structures and cyclic structures with branches. A substantially linear organopolysiloxane is generally preferred. Specifically, a linear diorganopolysiloxane in which the molecular chain is composed primarily of repeating diorganosiloxane units and the molecular chain is capped at both ends with triorganosiloxy groups is preferred. Also, component (A) may be a polymer composed of a single type of siloxane unit, or may be a copolymer composed of two or more types of siloxane units. The positions of the silicon-bonded alkenyl groups on component (A) are not particularly limited; these alkenyl groups may be bonded only to either silicon atoms at the ends of the molecular chain or to non-terminal silicon atoms on the molecular chain (silicon atoms located partway along the molecular chain), or may be bonded to both.

Component (A) is exemplified by organopolysiloxanes of average compositional formula (2) below

R³_{b}R⁴_{c}SiO_{(4-b-c)/2} (2)

(wherein each R³ is independently an unsubstituted or substituted monovalent hydrocarbon group without aliphatic unsaturated bonds; each R⁴ is independently an alkenyl group; 'b' is a positive number from 0.5 to 2.5, preferably from 0.8 to 2.2; 'c' is a positive number from 0.0001 to 0.2, preferably from 0.0005 to 0.1; and b+c is a positive number that is generally from 0.8 to 2.7, preferably from 0.9 to 2.2) which have at least 0.1 silicon-bonded alkenyl group per molecule.

R³ is an unsubstituted or substituted monovalent hydrocarbon group of 1 to 10 carbon atoms which has no aliphatic unsaturated bonds. Specific examples of R³ include alkyl groups such as methyl, ethyl, propyl, isopropyl, butyl, isobutyl, tert-butyl, hexyl, octyl and decyl groups; aryl groups such as phenyl, tolyl, xylyl and naphthyl groups; cycloalkyl groups such as cyclopentyl and cyclohexyl groups; aralkyl groups such as benzyl, 2-phenylethyl and 3-phenylpropyl groups; and any of these hydrocarbon groups in which some or all hydrogen atoms bonded to carbon atoms are substituted with chlorine, bromine, iodine or other halogen atoms, cyano groups or the like, examples of which include chloromethyl, 2-bromoethyl, 3,3,3-trifluoropropyl and cyanoethyl groups.

Of these, methyl groups, phenyl groups, and combinations of both are preferred. Component (A) in which the R³ groups are methyl groups, phenyl groups or combinations of both are preferred become they are easy to synthesize and have a good chemical stability. In cases where an organopolysiloxane having, in particular, a good solvent resistance is used as component (A), the R³ groups are more preferably methyl groups, phenyl groups, or a combination of both, in combination with 3,3,3-trifluoropropyl groups.

R⁴ is exemplified by alkenyl groups of 2 to 8 carbon atoms. Specific examples of R⁴ include vinyl, allyl, 1-propenyl, isopropenyl, 1-butenyl, isobutenyl and hexenyl groups. Of these, vinyl groups are preferred. Component (A) in which the R⁴ groups are vinyl groups are easy to synthesize and have a good chemical stability.

Specific examples of component (A) include dimethylsiloxane/methylvinylsiloxane copolymers capped at both ends of the molecular chain with trimethylsiloxy groups, methylvinylpolysiloxanes capped at both ends of the molecular chain with trimethylsiloxy groups, dimethylsiloxane/methylvinylsiloxane/methylphenylsiloxane copolymers capped at both ends of the molecular chain with trimethylsiloxy groups, dimethylsiloxane/methylvinylsiloxane/diphenylsiloxane copolymers capped at both ends of the molecular chain with trimethylsiloxy groups, dimethylpolysiloxanes capped at both ends of the molecular chain with dimethylvinylsiloxy groups, methylvinylpolysiloxanes capped at both ends of the molecular chain with dimethylvinylsiloxy groups, dimethylsiloxane/methylvinylsiloxane copolymers capped at both ends of the molecular chain with dimethylvinylsiloxy groups, dimethylsiloxane/methylvinylsiloxane/methylphenylsiloxane copolymers capped at both ends of the molecular chain with dimethylvinylsiloxy groups, dimethylsiloxane/methylvinylsiloxane/diphenylsiloxane copolymers capped at both ends of the molecular chain with dimethylvinylsiloxy groups, dimethylpolysiloxanes capped at both ends of the molecular chain with divinylmethylsiloxy groups, dimethylpolysiloxanes capped at both ends of the molecular chain with trivinylsiloxy groups, dimethylpolysiloxanes capped at the ends of the molecular chain with a trimethylsiloxy group and a dimethylvinylsiloxy group, dimethylsiloxane/methylvinylsiloxane copolymers capped at the ends of the molecular chain with a trimethylsiloxy group and a dimethylvinylsiloxy group, dimethylsiloxane/diphenylsiloxane copolymers capped at the ends of the molecular chain with a trimethylsiloxy group and a dimethylvinylsiloxy group and dimethylsiloxane/diphenylsiloxane/methylvinylsiloxane copolymers capped at the ends of the molecular chain with a trimethylsiloxy group and a dimethylvinylsiloxy group. These organopolysiloxanes may be of one type used alone, or two or more types may be used in combination. Also, concomitant use may be made of one, two or more such organopolysiloxanes of differing degrees of polymerization.

Component (A) has a viscosity at 25°C which is preferably from 0.1 to 20,000 mPa·s, and more preferably from 10 to 1,000 mPa.s. At a viscosity below this lower limit, the thermally conductive inorganic filler in the resulting silicone composition tends to precipitate out, and so the composition may have a poor long-term shelf stability. At a viscosity in excess of the upper limit, the resulting silicone composition tends to have a very poor flowability, which may lead to an inferior workability. In this invention, the absolute viscosity is a measured value obtained with a spiral viscometer such as the Malcom viscometer (Type PC-10AA).

### [Component (B)]

Component (B) is an organohydrogenpolysiloxane having on average at least one silicon-bonded hydrogen atom (Si-H group) per molecule. One such compound may be used alone or two or more may be used in suitable combination. The organohydrogenpolysiloxane of component (B) is a silicone composition curing agent which has on average at least one, preferably two or more (2 to about 300), and more preferably three or more (3 to about 200), silicon-bonded hydrogen atoms (Si-H groups) per molecule. Component (B) is not particularly limited as to its molecular structure, and may be a resinous substance having, for example, a linear, branched, cyclic or three-dimensional network structure. Compounds of average compositional formula (3) below may be used.

R⁵_{d}HₑSiO_{(4-d-e)/2} (3)

(wherein R⁵ is an unsubstituted or substituted monovalent hydrocarbon group, excluding aliphatic unsaturated hydrocarbon groups; 'd' is a positive number from 1.0 to 3.0, preferably from 0.5 to 2.5; `e' is a positive number from 0.05 to 2.0, preferably from 0.01 to 1.0; and d+e is a positive number from 0.5 to 3.0, preferably from 0.8 to 2.5)

R⁵ is exemplified by unsubstituted or halogen-substituted monovalent hydrocarbon groups of generally about 1 to 10, preferably about 1 to 8, carbon atoms without aliphatic unsaturated bonds, including alkyl groups such as methyl, ethyl, propyl, butyl, pentyl, hexyl, isopropyl, isobutyl, tert-butyl and cyclohexyl groups; aryl groups such as phenyl, tolyl and xylyl groups; aralkyl groups such as benzyl and phenethyl groups; and halogenated alkyl groups such as 3-chloropropyl and 3,3,3-trifluoropropyl groups. Methyl, ethyl, propyl, phenyl and 3,3,3-trifluoropropyl groups are preferred; a methyl group is more preferred.

Specific examples of the organohydrogenpolysiloxane of component (B) include 1,1,3,3-tetramethyldisiloxane, 1,3,5,7-tetramethylcyclotetrasiloxane, methylhydrogencyclopolysiloxane, methylhydrogensiloxane/dimethylsiloxane cyclic copolymers, tris(dimethylhydrogensiloxy)methylsilane, tris(dimethylhydrogensiloxy)phenylsilane, dimethylsiloxane/methylhydrogensiloxane copolymers capped at both ends of the molecular chain with dimethylhydrogensiloxy groups, methylhydrogenpolysiloxanes capped at both ends of the molecular chain with dimethylhydrogensiloxy groups, methylhydrogenpolysiloxanes capped at both ends of the molecular chain with trimethylsiloxy groups, dimethylpolysiloxanes capped at both ends of the molecular chain with dimethylhydrogensiloxy groups, dimethylsiloxane/diphenylsiloxane copolymers capped at both ends of the molecular chain with dimethylhydrogensiloxy groups, dimethylsiloxane/methylhydrogensiloxane copolymers capped at both ends of the molecular chain with trimethylsiloxy groups, dimethylsiloxane/diphenylsiloxane/methylhydrogensiloxane copolymers capped at both ends of the molecular chain with trimethylsiloxy groups, dimethylsiloxane/methylhydrogensiloxane copolymers capped at both ends of the molecular chain with dimethylhydrogensiloxy groups, copolymers of H(CH₃)₂SiO_{1/2} units and SiO₂ units, copolymers of H(CH₃)₂SiO_{1/2} units, (CH₃)₃SiO_{1/2} units and SiO₂ units, and mixtures of two or more of these organohydrogenpolysiloxanes.

Component (B) has a viscosity at 25°C which, although not particularly limited, is preferably from 0.5 to 1,000,000 mPa·s, and more preferably from 1 to 100,000 mPa. s.

In this invention, because the silicone composition contains the product obtained by the reaction of Si-H groups in component (B) with silicon-bonded alkenyl groups in component (A) at a molar ratio (Si-H)/Si-Vi) therebetween of more than 8.0 and up to 20.0, component (A) and component (B) are compounded so as to achieve a molar ratio within this range. Amounts such as to set this molar ratio to from 10.0 to 15.0 are preferred. When the molar ratio is below the lower limit indicated above, depending on the conditions of the other ingredients, because the organopolysiloxane obtained by reacting component (A) with component (B) lacks sufficient Si-H residues relative to the active sites on component (C), a high modulus is not achieved at 150°C and the ratio between the storage moduli at 150°C and 25°C, expressed as G'(150°C)/G'(25°C), is less than 2, creeping of the silicone composition may arise during thermal cycling, or the viscosity of the silicone composition may become high, resulting in a silicone composition that has a poor coatability. On the other hand, when this molar ratio exceeds the upper limit, the active sites on component (C) end up being buried by component (A) and unreacted component (B), so that active sites on component (C) cannot be bridged by Si-H groups in the organopolysiloxane obtained by the reaction of components (A) and (B). As a result, the ratio G'(150°C)/G'(25°C) between the storage moduli at 150°C and 25°C of the resulting silicone composition falls below 2 and creeping of the silicone composition may arise during thermal cycling. The molar ratio (Si-H)/(Si-Vi) for the overall silicone composition is preferably more than 8.0 and up to 20.0, and more preferably from 10.0 to 15.0.

The silicone composition preferably includes a platinum metal-based curing catalyst, which is an addition reaction catalyst for promoting the above reaction and is exemplified by well-known catalysts that can be used in hydrosilylation reactions. These may be of one type used alone or two or more may be used in suitable combination. Of such catalysts, hydrosilylation catalysts obtained by diluting a platinum complex of chloroplatinic acid, chloroplatinate or the like with an organopolysiloxane containing alkenyl groups such as vinyl groups are preferred. These can be obtained by mixing the platinum complex with a vinyl group-containing organopolysiloxane. When a solvent such as toluene is included in the platinum complex, the solvent should be removed following mixture.

When an addition reaction catalyst is used, it should be used in a catalytic amount. Expressed in terms of the weight of the platinum metal element with respect to component (A), this is generally from about 0.1 ppm to about 2,000 ppm.

### [Component (C)]

Component (C) is an inorganic filler selected from the group consisting of metal oxides and metal nitrides and has an average particle size of not more than 3 µm. This inorganic filler is an ingredient which has a large specific surface area and, through interactions with the reaction product of components (A) and (B) that is rich in Si-H groups, increases the storage modulus at 150°C. It is also an ingredient for arranging the particle size distribution of the thermally conductive inorganic filler of component (D) so as to achieve closest packing and increase the loading, thereby enhancing the thermal conductivity of the silicone composition.

Preferred materials include aluminum oxide powder, zinc oxide powder, magnesium oxide, aluminum nitride and boron nitride powder. These are electrically insulating materials and may be selected from an industrially broad range of particle size grades. Given that they are readily available as resources and can be acquired at a relatively low cost, they are widely used as heat-dissipating materials. Because -OH residues are present at the surface in the case of metal oxides and -NH₂ residues are present at the surface in the case of metal nitrides, these can be expected to interact with the Si-H residues present within the organopolysiloxane.

Also, component (C) is preferably an inorganic filler having a point of zero charge (PZC) of at least pH 6. At a PZC of less than pH 6, the number of sites that interact with Si-H groups at the surface of the inorganic filler decreases and so an increase in the storage modulus at 150°C does not appear. As a result, creep may arise. The PZC is the pH of the aqueous solution at which the surface charge of the metal oxide and metal nitride within the solution becomes zero.

The inorganic filler of component (C) in this invention may be used in an amorphous, granular or spherical form. Of these, from the standpoint of the loading ability in particular, the use of a spherical inorganic filler is preferred.

The average particle size of component (C) is not more than 3 µm, and more preferably from 0.5 to 2.5 µm. When the average particle size is too small, the flowability of the silicone composition decreases; when the average particle size is too large, the number of sites that interact with Si-H groups decreases and a sufficient rise in the storage modulus at 150°C may not be observed. In this invention, the average particle sizes of components (C) and (D) are volume cumulative mean particle diameters D₅₀ (or median diameters) measured by a laser diffraction scattering method using, for example, the Microtrac MT-3300EX, which is a particle size analyzer manufactured by Nikkiso Co., Ltd.

The component (C) content in the silicone composition is preferably from 50 to 5,000 parts by weight, and more preferably from 100 to 4,000 parts by weight, per 100 parts by weight of components (A) and (B) combined. When the component (C) content is too low, creep may arise in the resulting silicone composition or the thermal conductivity may decrease. On the other hand, when it is too high, the viscosity rises, which may make it difficult to uniformly apply the silicone composition. Component (C) is preferably in the form of a mixture obtained by first heating and mixing it in components (A) and (B).

### [Component (D)]

Component (D) is a thermally conductive inorganic filler having an average particle size of at least 5 µm. Examples include aluminum, silver, copper, nickel, zinc oxide, aluminum oxide, silicon oxide, magnesium oxide, aluminum nitride, boron nitride, silicon nitride, silicon carbide, diamond, graphite and metallic silicon. One such substance may be used alone or two or more may be used in suitable combination. The zinc oxide, aluminum oxide, magnesium oxide, aluminum nitride and boron nitride overlap with component (C), but the average particle sizes differ.

The average particle size of component (D) is at least 5 µm, preferably from 5 to 200 µm, and more preferably from 6 to 100 µm. At an average particle size below 5 µm, the silicone composition becomes non-uniform and the creep resistance worsens. When the average particle size is too large, the silicone composition may become non-uniform and the creep resistance may worsen.

The content of component (D) in the silicone composition is preferably from 100 to 8,000 parts by weight, and more preferably from 200 to 7,000 parts by weight, per 100 parts by weight of components (A) and (B) combined.

The combined amount of components (C) and (D) included in the silicone composition per 100 parts by weight of components (A) and (B) combined is from 3,500 to 12,000 parts by weight, preferably from 4,000 to 10,000 parts by weight, more preferably more than 5,000 parts by weight and up to 9,000 parts by weight, and even more preferably more than 6,000 parts by weight and up to 9,000 parts by weight. When this combined amount is below the lower limit, a thermal conductivity of 4 W/m- K cannot be achieved; when it exceeds the upper limit, a sufficient coating performance cannot be obtained. The weight ratio of component (C) to component (D) is preferably from 45:55 to 5:95.

### [Component (E)]

A hydrolyzable organopolysiloxane (E) may be included in the silicone composition of the invention. Component (E) functions as a wetter; components (C) and (D) that have been surface-treated with the hydrolyzable organopolysiloxane (E) become surface-treated inorganic fillers. Even when the silicone composition contains high loadings of components (C) and (D), the flowability of the silicone composition is retained, enabling this composition to be imparted with a good handleability.

Component (E) is an organopolysiloxane of general formula (1) below

-SiR¹ₐ(OR²)₃₋ₐ (1)

(wherein R¹ is an unsubstituted or substituted monovalent hydrocarbon group, R² is an alkyl group, alkoxyalkyl group or acyl group; and `a' is 0, 1 or 2) having at least one silyl group per molecule and a viscosity at 25°C of from 0.1 to 30,000 mPa. s.

### Examples of component (E) include organopolysiloxanes of general formula (4) below

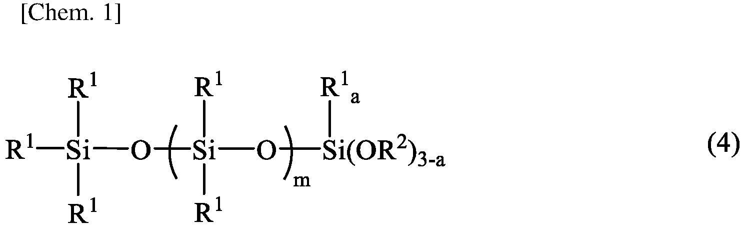

(wherein each R¹ is independently an unsubstituted or substituted monovalent hydrocarbon group, each R² is independently an alkyl, alkoxyalkyl or acyl group, `m' is an integer from 2 to 100, and 'a' is 0, 1 or 2).

In the above formula, each R¹ is independently an unsubstituted or substituted monovalent hydrocarbon group, preferably one that includes no aliphatic unsaturated groups, and the number of carbon atoms is preferably from 1 to 10, more preferably from 1 to 6, and even more preferably from 1 to 3. Examples include linear alkyl groups, branched-chain alkyl groups, cyclic alkyl groups, aryl groups, aralkyl groups and halogenated alkyl groups. Examples of linear alkyl groups include methyl, ethyl, propyl, hexyl, octyl, and decyl groups. Examples of branched-chain alkyl groups include isopropyl, isobutyl, tert-butyl and 2-ethylhexyl groups. Examples of cyclic alkyl groups include cyclopentyl and cyclohexyl groups. Examples of aryl groups include phenyl and tolyl groups. Examples of aralkyl groups include 2-phenylethyl and 2-methyl-2-phenylethyl groups. Examples of halogenated alkyl groups include 3,3,3-trifluoropropyl, 2-(nonafluorobutyl)ethyl and 2-(heptadecafluorooctyl)ethyl groups. Of these, methyl and phenyl groups are preferred as R¹.

In the above formula, each R² is independently an alkyl, alkoxyalkyl or acyl group. The number of carbon atoms is preferably from 1 to 8. The alkyl groups are exemplified by linear alkyl groups, branched-chain alkyl groups and cyclic alkyl groups. Specific examples include the groups mentioned above in connection with R¹. Examples of alkoxyalkyl groups include methoxyethyl and methoxypropyl groups. Examples of acyl groups include acetyl and octanoyl groups. Of these, R² is preferably an alkyl group, with methyl and ethyl groups being more preferred. Also, 'm' is from 2 to 100, and preferably from 5 to 50; 'a' is 0, 1 or 2, and preferably 0.

Specific preferred examples of component (E) include the following.

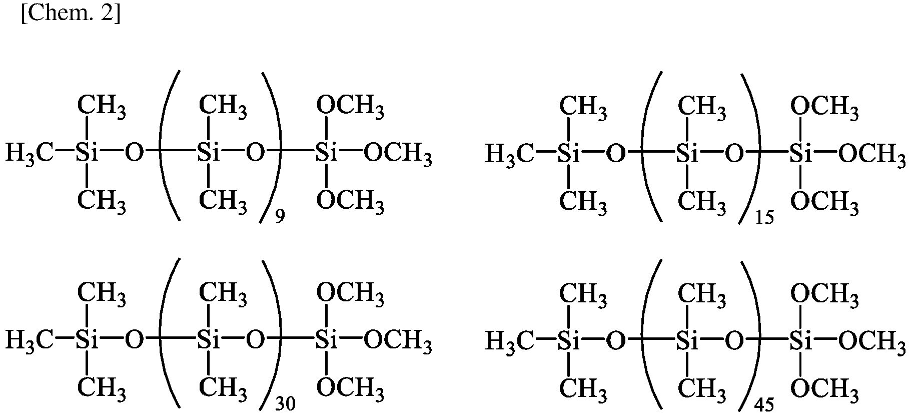

When component (E) is included, the content thereof per 100 parts by weight of components (A) and (B) combined is preferably from 50 to 600 parts by weight, and more preferably from 60 to 500 parts by weight. At less than 50 parts by weight, the silicone composition may thicken and become impossible to discharge. On the other hand, at more than 600 parts by weight, the viscosity may become too low and the creep resistance may decline.

### [Other Ingredients]

In addition to the ingredients mentioned above, the silicone composition of the invention may also include optional ingredients such as fillers within ranges that do not detract from the advantage effects of the invention. One such ingredient may be used alone or two or more may be used in suitable combination. Examples include the following non-reinforcing fillers: wollastonite, talc, calcium sulfate, magnesium carbonate, clays such as kaolin; aluminum hydroxide, magnesium hydroxide, graphite, barite, copper carbonates such as malachite; nickel carbonates such as zarachite; barium carbonates such as witherite; strontium carbonates such as strontianite; silicates such as forsterite, sillimanite, mullite, pyrophyllite, kaolinite and vermiculite; diatomaceous earth; as well as these fillers whose surfaces have been treated with organosilicon compounds. When such a filler is included, the content of this filler in the silicone composition is preferably not more than 100 parts by weight per 100 parts by weight of components (A) and (B) combined.

A tackifier may be included so as to enhance the adhesive properties of the silicone composition. The tackifier may be of one type used alone or two or more types may be used in suitable combination. Specific examples of tackifiers include alkylalkenyldialkoxysilanes such as methylvinyldimethoxysilane, ethylvinyldimethoxysilane, methylvinyldiethoxysilane and ethylvinyldiethoxysilane; alkylalkenyldioximesilanes such as methylvinyldioximesilane and ethylvinyldioximesilane; alkylalkenyldiacetoxysilanes such as methylvinyldiacetoxysilane and ethylvinyldiacetoxysilane; alkylalkenyldihydroxysilanes such as methylvinyldihydroxysilane and ethylvinyldihydroxysilane; organotrialkoxysilanes such as methyltrimethoxysilane, vinyltrimethoxysilane, allyltrimethoxysilane, 3-methacryloxypropyltrimethoxysilane, 3-glycidoxypropyltrimethoxysilane, 3-aminopropyltrimethoxysilane, N-(2-aminoethyl)-3-aminopropyltrimethoxysilane, bis(trimethoxysilyl)propane and bis(trimethoxysilyl)hexane; isocyanurate compounds such as triallyl isocyanurate, diallyl(3-trimethoxysilyl) isocyanurate, tris(3-trimethoxysilylpropyl) isocyanurate, tris(3-triethoxysilylpropyl) isocyanurate and tris(3-tripropoxysilylpropyl) isocyanurate; titanium compounds such as tetraethyl titanate, tetrapropyl titanate, tetrabutyl titanate, tetra(2-ethylhexyl) titanate, titanium ethylacetonate and titanium acetylacetonate; aluminum compounds such as ethyl acetoacetate aluminum diisopropylate, aluminum tris(ethyl acetoacetate), alkyl acetoacetate aluminum diisopropylate, aluminum tris(acetylacetonate) and aluminum monoacetylacetonate bis(ethyl acetoacetate); and zirconium compounds such as zirconium acetylacetonate, zirconium butoxyacetylacetonate, zirconium bis(acetylacetonate) and zirconium ethyl acetoacetate.

When a tackifier is included, the tackifier content in the silicone composition, although not particularly limited, is preferably from 0.01 to 10 parts by weight per 100 parts by weight of components (A) and (B) combined.

### [Production Method]

Production of the silicone composition includes, for example, the following steps:
(I) mixing components (A), (B), (C), (D) and, optionally, (E) together with a platinum metal-based curing catalyst in such a way that the molar ratio (Si-H/Si-Vi) of Si-H groups in component (B) to silicon-bonded alkenyl groups in component (A) is more than 8.0 and up to 20.0; and
(II) reacting component (A) with component (B) by heating the resulting mixture at between 100°C and 180°C for a period of from 30 minutes to 4 hours.

(I) Components (A), (B), (C), (D) and, optionally, (E), a platinum metal-based curing catalyst and, depending on the case, other ingredients as well are added and mixed together using a mixer such as the Trimix, Twinmix or Planetary Mixer (all registered trademarks of mixers manufactured by Inoue Mfg., Inc.), the Ultra Mixer (registered trademark of mixers manufactured by Mizuho Industrial Co., Ltd.) or the HIVIS DISPER MIX (registered trademark of mixers manufactured by Tokushu Kika Kogyo KK). The temperature at which the liquid substances and the inorganic fillers are mixed together is not particularly limited; mixing may be carried out at room temperature for 5 to 30 minutes.
(II) Following mixture, heating is carried out at between 100°C and 180°C for a period of from 30 minutes to 4 hours to effect the reaction between component (A) and component (B). After heating, mixture may be carried out under reduced pressure.

### [Silicone Composition]

The silicone composition of the invention includes the reaction product (cured product) of components (A) and (B). As mentioned above, it may be a cured product obtained by curing a composition that includes components (A), (B), (C), (D) and, optionally, component (E), and also includes a platinum metal-based curing catalyst. The silicone composition has an absolute viscosity at 25°C which is from 100 to 1,000 Pa·s, and preferably from 150 to 800 Pa.s. At an absolute viscosity below 100 Pa·s, dripping of the silicone composition occurs during coating, lowering the coatability. In addition, the precipitation of components (C) and (D) may arise during long-term storage. On the other hand, at above 1,000 Pa·s, the coatability declines and the production efficiency decreases. For example, a silicone composition having an absolute viscosity in the above range can be obtained by adjusting the degree of crosslinking of components (A) and (B) and the amounts of components (C) and (D).

The highly thermally conductive silicone composition of the invention has a thermal conductivity of at least 4 W/m- K, and preferably at least 5 W/m·K. The upper limit, although not particularly limited, may be set to 10 W/m- K or less. Because the inventive composition has such an excellent thermal conductivity, it is well-suited for use as a thermal interface.

When the storage moduli are measured under the rheometer measurement conditions shown below, from the standpoint of preventing creep, it is preferable for the ratio G'(150°C)/G'(25°C) to be large. Specifically, a value of from 2 to 20 is preferred; a value of from 2 to 6 is more preferred. A HAAKE MARS rheometer (Thermo Fisher Scientific) may be used for measurement.

### Rheometer measurement conditions

| | |
|---|---|
| Measuring geometry: | parallel plate P20 Ti |
| Measuring gap: | 1.00 mm (liquid volume: 0.4 mL) |
| Testing mode: | Frequency sweep in controlled deformation mode |
| Deformation conditions: | CD-Auto Strain 1.00±0.05% |
| Measuring frequency: | 0.1 to 10 Hz |
| Measuring temperatures: | 25°C±1°C, 150°C±1°C after raising temperature to 150°C at 15°C/min |

### EXAMPLES

The invention is illustrated more concretely below by way of Examples and Comparative Examples, although the invention is not limited by these Examples. In the Examples, the viscosities of component (A), component (B) and the silicone compositions are values measured at 25°C with a Malcom viscometer.

The ingredients used in the Examples and Comparative Examples are described below.

### [Addition Reaction Catalyst]

Chloroplatinic acid H₂PtCl₆·6H₂O (platinum content, 37.6 wt%), 8.0 g, was placed in a 100 mL reaction flask equipped with a reflux condenser, a thermometer and a stirrer, following which 40.0 g of ethanol and 16.0 g of divinyltetramethyldisiloxane were added. Reaction was effected by 50 hours of heating at 70°C, after which the reaction mixture was neutralized for 2 hours by gradually adding 16.0 g of sodium bicarbonate under stirring of the mixture at room temperature. The reaction mixture was then suction filtered and the filtrate was vacuum distilled, substantially removing the ethanol and excess divinyltetramethyldisiloxane, following which the flask contents were diluted with toluene, bringing the total amount up to 600 g (platinum content, 0.5 wt%).

Next, 290 g of dimethylpolysiloxane capped at both ends of the molecular chain with dimethylvinylsiloxy groups and having a viscosity of 600 mPa·s was added to the above toluene solution of a platinum-vinylsiloxane complex and stirred, and the toluene was substantially removed by vacuum distillation at 60°C/20 torr, thereby giving the hydrosilylation catalyst (platinum content, 1.0 wt%).

### Component (A)

(A-1) Dimethylpolysiloxane capped at both ends of the molecular chain with dimethylvinylsiloxy groups and having a viscosity of 600 mPa·s (vinyl group content, 0.015 mol/100 g)
(A-2) Dimethylsiloxane/diphenylsiloxane copolymer capped at the ends of the molecular chain with trimethylsiloxy and vinyldimethylsiloxy groups and having a viscosity of 700 mPa.s (vinyl group content, 0.0049 mol/100 g)

### Component (B)

(B-1) An organohydrogenpolysiloxane of the following formula 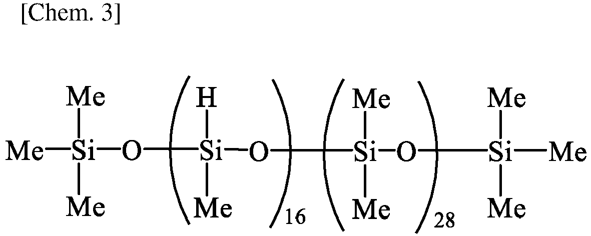 (wherein "Me" represents a methyl group and the bonding sequence of the respective siloxane units is not limited to that shown in the formula) (Si-H group content, 0.0055 mol/g)

### (C) Inorganic Filler

(C-1) Type II zinc oxide (JIS standard, average particle size, 1 µm): PZC 9.5
(C-2) Aluminum oxide powder (average particle size, 1 µm): PZC 8.5
(C-3) Magnesium oxide powder (average particle size, 1 µm): PZC 11.5
(C-4) Aluminum nitride powder (average particle size, 1 µm): PZC 9.5
(C-5) Silicon carbide (average particle size, 1 µm): PZC 4.0 (comparative product)

### (D) Thermally Conductive Inorganic Filler

(D-1) Aluminum oxide powder (average particle size, 10 µm)
(D-2) Aluminum oxide powder (average particle size, 45 µm)

### Component (E)

(E-1) Organopolysiloxane of the following formula

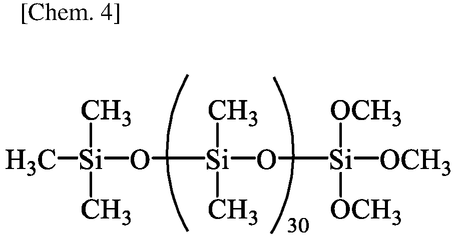

### Component (F)

(F-1) The above-mentioned platinum-based hydrosilylation catalyst

Highly thermally conductive silicone compositions formulated as shown in the table were produced by the following method.

### [Examples, Comparative Examples]

### Production of Thermally Conductive Silicone Composition

Components (A), (B), (C), (D) and (E) and the hydrosilylation catalyst were compounded at room temperature and mixed for 5 to 10 minutes using a planetary mixer (component (C) was used in the form of a mixture obtained by preliminary mixture under heating within components (A) and (B)). The resulting mixture was heated to 160°C and then mixed for 180 minutes at normal pressure and 60 minutes under reduced pressure.

The properties of the thermally conductive silicone compositions were measured by the methods shown below.

### [Measurement of Thermal Conductivity]

Measured at 25°C by the hot disk method using the TPA-501 thermophysical property analyzer from Kyoto Electronics Manufacturing Co., Ltd.

### [Viscosity Measurement]

The viscosities indicated are values measured at 25°C using the Malcom viscometer (Type PC-10AA). In the coating process, a silicone composition having a viscosity greater than 1,000 Pa-s is thought to be impossible to use in practice.

### [Ratio of Silicone Composition Storage Moduli at 25°C and 150°C]

The shear storage moduli (G') of the resulting silicone compositions at 25°C and 150°C were measured under the following conditions, and the ratio G'(150°C)/G'(25°C) therebetween was calculated.

| | |
|---|---|
| Measuring geometry: | parallel plate P20 Ti |
| Measuring gap: | 1.00 mm (liquid volume: 0.4 mL) |
| Testing mode: | Frequency sweep in controlled deformation mode |
| Deformation conditions: | CD-Auto Strain 1.00±0.05% |
| Measuring frequency: | 0.1 to 10 Hz |
| Measuring temperatures: | 25°C±1°C, 150°C±1°C after raising temperature to 150°C at 15°C/min |

### [Creep Test on Silicone Composition]

A given amount (0.325 mL) of the prepared silicone composition was placed on a glass slide, a 1 mm spacer was inserted and the composition was sandwiched with another glass slide, thereby creating a disk-shaped sample having a diameter of about 20 mm and a thickness of 1 mm.

The sample sandwiched between glass slides was arranged in a vertical state, a cycle test under cooling and heating test conditions of -40°C/30 minutes ⇔ 150°C/30 minutes was carried out, and the condition of the sample after 250 cycles was examined.

In cases where the silicone composition that had cured in a disk shape was displaced from the original position, the test results was indicated as "Creep"; in cases where there was no displacement whatsoever from the original position, the result was indicated as "No creep."

**[Table 1]**

| Formulation (pbw) | | H equivalent Vinyl equivalent (mol/g) | Density (g/cm³) | Example | | | | | | | |
|---|---|---|---|---|---|---|---|---|---|---|---|
| | | | | 1 | 2 | 3 | 4 | 5 | 6 | 7 | 8 |
| (A) | A-1 | 1.5E-04 | 1.0 | 15.0 | 15.0 | 7.5 | 7.5 | 50 | 7.5 | 15.0 | 15.0 |
| | A-2 | 4.9E-05 | 1.0 | 35.0 | 35.0 | 42.5 | 42.5 | | 42.5 | 35.0 | 35.0 |
| (B) | B-1 | 5.5E-03 | 1.0 | 9.5 | 8.4 | 10.7 | 5.5 | 15.1 | 6.1 | 8.4 | 8.4 |
| (C) | C-1 | N.A. | 5.6 | 1,369 | 1,678 | 1,583 | 919 | 2,250 | | | |
| | C-2 | N.A. | 3.9 | | | | | | 952 | | |
| | C-3 | N.A. | 3.7 | | | | | | | 904 | |
| | C-4 | N.A. | 3.3 | | | | | | | | 807 |
| (D) | D-1 | N.A. | 3.9 | 1,597 | 1,958 | 1,188 | 1,073 | 2,625 | 1,276 | 1,597 | 1,597 |
| | D-2 | N.A. | 3.9 | 1,597 | 1,958 | 1,188 | 1,073 | 2,625 | 1,276 | 1,597 | 1,597 |
| (E) | E-1 | N.A. | 1.0 | 200 | 250 | 150 | 117 | 380 | 150 | 200 | 200 |
| (F) | F-1 | N.A. | 1.0 | 0.2 | 0.2 | 0.2 | 0.2 | 0.2 | 0.2 | 0.2 | 0.2 |
| (B) Si-H groups/(A) Si-Vi groups (molar ratio) | | | | 13.0 | 11.6 | 18.3 | 9.4 | 11.0 | 10.4 | 11.6 | 11.6 |
| Parts by weight (pbw) of ((C) + (D)) per 100 pbw of ((A)+(B)) | | | | 7,669 | 9,579 | 6,522 | 5,523 | 11,521 | 6,246 | 7,017 | 6,851 |
| Parts by weight (pbw) of ((E)) per 100 pbw of ((A)+(B)) | | | | 336 | 428 | 247 | 211 | 584 | 267 | 342 | 342 |
| Thermal conductivity (W/m·K) | | | | 5.6 | 6.5 | 5.3 | 5.7 | 5.4 | 5.3 | 5.7 | 5.9 |
| Viscosity (Pa·s) | | | | 620 | 880 | 912 | 750 | 280 | 560 | 680 | 650 |
| G'(150°C)/G'(25°C) | | | | 2.6 | 2.3 | 3.0 | 2.3 | 2.2 | 2.0 | 2.4 | 2.8 |
| Creep test | | | | No creep | No creep | No creep | No creep | No creep | No creep | No creep | No creep |

**[Table 2]**

| Formulation (pbw) | | H equivalent Vinyl equivalent (mol/g) | Density (g/cm³) | Comparative Example | | | | | | |
|---|---|---|---|---|---|---|---|---|---|---|
| | | | | 1 | 2 | 3 | 4 | 5 | 6 | 7 |
| (A) | A-1 | 1.5E-04 | 1.0 | 15.0 | 15.0 | 7.5 | 15.0 | 15.0 | 15.0 | 15.0 |
| | A-2 | 4.9E-05 | 1.0 | 35.0 | 35.0 | 42.5 | 35.0 | 35.0 | 35.0 | 35.0 |
| (B) | B-1 | 5.5E-03 | 1.0 | 6.5 | 8.4 | 4.1 | 16.0 | 16.0 | 16.0 | 7.3 |
| (C) | C-1 | N.A. | 5.6 | 585 | 2,130 | 1,083 | 1,369 | | | |
| | C-2 | N.A. | 3.9 | | | | | 952 | | |
| | C-3 | N.A. | 3.7 | | | | | | 807 | |
| | C-5 (comp. product) | N.A. | 3.2 | | | | | | | 800 |
| (D) | D-1 | N.A. | 3.9 | 683 | 2,485 | 1,264 | 1,597 | 1,597 | 1,597 | 1,597 |
| | D-2 | N.A. | 3.9 | 683 | 2,485 | 1,264 | 1,597 | 1,597 | 1,597 | 1,597 |
| (E) | E-1 | N.A. | 1.0 | 110 | 200 | 150 | 200 | 200 | 200 | 200 |
| (F) | F-1 | N.A. | 1.0 | 0.2 | 0.2 | 0.2 | 0.2 | 0.2 | 0.2 | 0.2 |
| (B) Si-H groups/(A) Si-Vi groups (molar ratio) | | | | 9.0 | 11.6 | 7.0 | 22.0 | 22.0 | 22.0 | 10.0 |
| Parts by weight (pbw) of ((C) + (D)) per 100 pbw of ((A)+(B)) | | | | 3,453 | 12,158 | 6,675 | 6,914 | 6,282 | 6,062 | 6,970 |
| Parts by weight (pbw) of ((E)) per 100 pbw of ((A)+(B)) | | | | 195 | 342 | 277 | 303 | 303 | 303 | 349 |
| Thermal conductivity (W/m·K) | | | | 3.8 | 6.9 | 5.5 | 5.0 | 5.1 | 5.3 | 5.6 |
| Viscosity (Pa·s) | | | | 310 | <1,000 | 610 | 480 | 420 | 400 | 420 |
| G'(150°C)/G'(25°C) | | | | 2.8 | 3.3 | 1.8 | 1.5 | 1.7 | 1.8 | 1.2 |
| Creep test | | | | No creep | No creep | Creep | Creep | Creep | Creep | Creep |

The results in Tables 1 and 2 demonstrate that the highly thermally conductive silicone compositions of the invention, in addition to having an excellent thermal conductivity, do not undergo creep during thermal cycling even when stored for a long period of time, and therefore exhibit excellent heat removal from electrical and electronic components that generate heat during use.

### INDUSTRIAL APPLICABILITY

The highly thermally conductive silicone compositions of the invention, in addition to having an excellent thermal conductivity, also have a good creep resistance and a good coatability, making them highly suitable for removing heat from electrical and electronic components that generate heat during use.

## Claims

1. A highly thermally conductive silicone composition comprising:
an organopolysiloxane which is the product of (A) an organopolysiloxane having on average at least 0.1 silicon-bonded alkenyl group per molecule reacted with (B) an organohydrogenpolysiloxane having on average at least 1 silicon-bonded hydrogen atom per molecule at a molar ratio (Si-H/Si-Vi) therebetween of silicon-bonded hydrogen atoms (Si-H groups) in component (B) to silicon-bonded alkenyl groups in component (A) of more than 8.0 and up to 20.0,
(C) an inorganic filler which has an average particle size of not more than 3 µm and is selected from the group consisting of metal oxides and metal nitrides, and
(D) a thermally conductive inorganic filler having an average particle size of at least 5 µm,
wherein the silicone composition has a combined amount of components (C) and (D) that is from 3,500 to 12,000 parts by weight per 100 parts by weight of components (A) and (B) combined, a thermal conductivity at 25°C as measured by the hot disk method in accordance with ISO 22007-2 of at least 4 W/m. K and an absolute viscosity at 25°C of from 100 to 1,000 Pa. s.

2. The highly thermally conductive silicone composition of claim 1, wherein the storage moduli measured with a rheometer under the following conditions:
| | |
|---|---|
| Measuring geometry: | parallel plate P20 Ti |
| Measuring gap: | 1.00 mm (liquid volume: 0.4 mL) |
| Testing mode: | Frequency sweep in controlled deformation mode |
| Deformation conditions: | CD-Auto Strain 1.00±0.05% |
| Measuring frequency: | 0.1 to 10 Hz |
| Measuring temperatures: | 25°C±1°C, 150°C±1°C after raising temperature to 150°C at 15°C/min |
are such that the ratio G'(150°C)/G'(25°C) therebetween is from 2 to 20.

3. The highly thermally conductive silicone composition of claim 1 or 2, wherein component (C) has a point of zero charge (PZC) of at least pH 6 and is one or more selected from the group consisting of aluminum oxide powder, zinc oxide powder, magnesium oxide, aluminum nitride and boron nitride powder.

4. The highly thermally conductive silicone composition of any one of claims 1 to 3, further comprising (E) a hydrolyzable organopolysiloxane.

5. The highly thermally conductive silicone composition of claim 4, wherein component (E) is an organopolysiloxane of general formula (1) below
-SiR¹ₐ(OR²)₃₋ₐ (1)
(where R¹ is an unsubstituted or substituted monovalent hydrocarbon group; R² is an alkyl group, alkoxyalkyl group or acyl group; and 'a' is 0, 1 or 2) having at least one silyl group per molecule and a viscosity at 25°C of from 0.1 to 30,000 mPa·s and is included in an amount of from 50 to 600 parts by weight per 100 parts by weight of components (A) and (B) combined.

6. A method for producing the highly thermally conductive silicone composition of any one of claims 1 to 3, which method comprises the steps of:
mixing components (A), (B), (C) and (D) together with a platinum metal-based curing catalyst in such a way that the molar ratio (Si-H/Si-Vi) of Si-H groups in component (B) to silicon-bonded alkenyl groups in component (A) is more than 8.0 and up to 20.0; and
reacting components (A) and (B) by heating the resulting mixture at between 100°C and 180°C for a period of from 30 minutes to 4 hours.

## Patentansprüche

1. Siliconzusammensetzung mit hoher Wärmeleitfähigkeit, die Folgendes umfasst:
ein Organopolysiloxan, das das Produkt einer Umsetzung von (A) einem Organopolysiloxan mit durchschnittlich zumindest 0,1 an Silicium gebundenen Alkenylgruppen pro Molekül mit (B) einem Organohydrogenpolysiloxan mit durchschnittlich zumindest 1 an Silicium gebundenem Wasserstoffatom pro Molekül in einem Molverhältnis (Si-H/Si-Vi) dazwischen von an Silicium gebunden Wasserstoffatomen (SiH-Gruppen) in Komponente (B) zu an Silicium gebundenen Alkenylgruppen in Komponente (A) von mehr als 8,0 und bis 20,0 ist,
(C) einen anorganischen Füllstoff, der eine durchschnittliche Teilchengröße von nicht mehr als 3 µm aufweist und aus der aus Metalloxiden und Metallnitriden bestehenden Gruppe ausgewählt ist, und
(D) einen wärmeleitenden anorganischen Füllstoff mit einer durchschnittlichen Teilchengröße von zumindest 5 µm,
wobei die Siliconzusammensetzung eine kombinierte Menge von Komponente (C) und (D) von 3.500 bis 12.000 Gewichtsteilen pro 100 Gewichtsteile der Komponenten (A) und (B) zusammen, eine mittels des Verfahrens mit einer heißen Platte gemäß ISO 22007-2 gemessenen Wärmeleitfähigkeit bei 25 °C von zumindest 4 W/m•K und eine absolute Viskosität bei 25 °C von 100 bis 1.000 Pa•s aufweist.

2. Siliconzusammensetzung mit hoher Wärmeleitfähigkeit nach Anspruch 1, wobei die mit einem Rheometer unter folgenden Bedingungen gemessenen Speichermoduli:
| | |
|---|---|
| Messgeometrie: | parallele Platte P20 Ti |
| Messspalt: | 1,00 mm (Flüssigkeitsvolumen: 0,4 ml) |
| Testmodus: | Frequenzsweep im kontrollierten Verformungsmodus |
| Verformungsbedingungen: | CD-Auto Strain 1,00 ± 0,05 % |
| Messfrequenz: | 0,1 bis 10 Hz |
| Messtemperaturen: | 25 °C ± 1 °C, 150 °C ± 1 °C nach Erhöhung der Temperatur auf 150 °C mit 15°C/min |
so sind, dass das Verhältnis G'(150 °C)/G'(25 °C) dazwischen 2 bis 20 beträgt.

3. Siliconzusammensetzung mit hoher Wärmeleitfähigkeit nach Anspruch 1 oder 2, wobei Komponente (C) einen Punkt der Nullladung (PZC) von zumindest pH 6 aufweist und eine oder mehrere aus der aus Aluminiumoxidpulver, Zinkoxidpulver, Magnesiumoxid, Aluminiumnitrid und Bornitridpulver bestehenden Gruppe ausgewählte ist.

4. Siliconzusammensetzung mit hoher Wärmeleitfähigkeit nach einem der Ansprüche 1 bis 3, die weiters (E) ein hydrolysierbares Organopolysiloxan umfasst.

5. Siliconzusammensetzung mit hoher Wärmeleitfähigkeit nach Anspruch 4, wobei Komponente (E) ein Organopolysiloxan der nachstehenden allgemeinen Formel (1)
-SiR¹ₐ(OR²)₃₋ₐ (1)
(worin R¹ eine unsubstituierte oder substituierte, einwertige Kohlenwasserstoffgruppe ist; R² eine Alkylgruppe, Alkoxyalkylgruppe oder Acylgruppe ist; und ,a' = 0, 1 oder 2 ist) mit zumindest einer Silylgruppe pro Molekül und einer Viskosität bei 25 °C von 0,1 bis 30.000 mPa•s ist und in einer Menge von 50 bis 600 Gewichtsteilen pro 100 Gewichtsteile der Komponenten (A) und (B) zusammen enthalten ist.

6. Verfahren zur Herstellung einer Siliconzusammensetzung mit hoher Wärmeleitfähigkeit nach einem der Ansprüche 1 bis 3, wobei das Verfahren die folgenden Schritte umfasst:
Mischen der Komponenten (A), (B), (C) und (D) zusammen mit einem Härtungskatalysator auf Platinmetallbasis so, dass das Molverhältnis (Si-H/Si-Vi) von Si-H-Gruppen in Komponente (B) zu an Silicium gebundenen Alkenylgruppen in Komponente (A) mehr als 8,0 und bis zu 20,0 beträgt; und
Umsetzen der Komponenten (A) und (B) durch Erhitzen des resultierenden Gemischs bei zwischen 100 °C und 180 °C über einen Zeitraum von 30 Minuten bis 4 Stunden.

## Revendications

1. Composition de silicone hautement thermiquement conductrice, comprenant :
un organopolysiloxane qui est le produit de (A) un organopolysiloxane présentant en moyenne au moins 0,1 groupe alcényle lié à du silicium par molécule mis à réagir avec (B) un organohydrogénopolysiloxane présentant en moyenne au moins 1 atome d'hydrogène lié à du silicium par molécule à un rapport molaire (Si-H/Si-Vi) entre les atomes d'hydrogène liés à du silicium (groupes Si-H) dans le composant (B) et les groupes alcényles liés à du silicium dans le composant (A) de plus de 8,0 et jusqu'à 20,0,
(C) une charge inorganique qui présente une taille de particule moyenne ne dépassant pas 3 µm et qui est choisie dans le groupe constitué d'oxydes métalliques et de nitrures métalliques, et
(D) une charge inorganique thermiquement conductrice présentant une taille de particule moyenne d'au moins 5 µm,
dans laquelle la composition de silicone présente une quantité combinée des composants (C) et (D) qui est de 3 500 à 12 000 parties en poids pour 100 parties en poids des composants (A) et (B) combinés, une conductivité thermique à 25°C telle que mesurée par le procédé du disque chaud conformément à la norme ISO 22007-2 d'au moins 4 W/m•K et une viscosité absolue à 25°C de 100 à 1 000 Pa•s.

2. Composition de silicone hautement thermiquement conductrice selon la revendication 1, dans laquelle les modules de stockage sont mesurés avec un rhéomètre dans les conditions suivantes :
| | |
|---|---|
| Géométrie de mesure : | plaque parallèle P20 Ti |
| Espace de mesure : | 1,00 mm (volume de liquide : 0,4 mL) |
| Mode de test : | balayage de fréquence en mode de déformation commandée |
| Conditions de déformation : | contrainte CD-Auto 1,00 ± 0,05 % |
| Fréquence de mesure : | de 0,1 à 10 Hz |
| mesure des températures : | 25°C ± 1°C, 150°C ± 1°C après élévation de la température à 150°C à 15°C/min |
sont tels que le rapport G' (150°C)/G' (25°C) entre eux est de 2 à 20.

3. Composition de silicone hautement thermiquement conductrice selon la revendication 1 ou 2, dans laquelle le composant (C) présente un point de charge nulle (PZC) d'au moins pH 6 et est un ou plusieurs choisis dans le groupe constitué de la poudre d'oxyde d'aluminium, de la poudre d'oxyde de zinc, de l'oxyde de magnésium, du nitrure d'aluminium et de la poudre de nitrure de bore.

4. Composition de silicone hautement thermiquement conductrice selon l'une quelconque des revendications 1 à 3, comprenant en outre (E) un organopolysiloxane hydrolysable.

5. Composition de silicone hautement thermiquement conductrice selon la revendication 4, dans laquelle le composant (E) est un organopolysiloxane de la formule générale (1) ci-dessous
-SiR¹ₐ(OR²)₃₋ₐ (1)
(où R¹ est un groupe hydrocarboné monovalent non substitué ou substitué ; R² est un groupe alkyle, un groupe alcoxyalkyle ou un groupe acyle ; et 'a' est 0, 1 ou 2) présentant au moins un groupe silyle par molécule et une viscosité à 25°C de 0,1 à 30 000 mPa•s et est inclus en une quantité de 50 à 600 parties en poids pour 100 parties en poids des composants (A) et (B) combinés.

6. Procédé de production de la composition de silicone hautement thermiquement conductrice selon l'une quelconque des revendications 1 à 3, lequel procédé comprend les étapes consistant à :
mélanger les composants (A), (B), (C) et (D) avec un catalyseur de durcissement à base de métal de platine de telle sorte que le rapport molaire (Si-H/Si-Vi) des groupes Si-H dans le composant (B) aux groupes alcényle liés à du silicium dans le composant (A) est supérieur à 8,0 et jusqu'à 20,0 ; et
faire réagir les composants (A) et (B) en chauffant le mélange résultant entre 100°C et 180°C pendant une période de 30 minutes à 4 heures.
